(19) Europäisches Patentamt
European Patent Office
Office européen des brevets

(11) EP 4 621 399 A1

(12) **EUROPEAN PATENT APPLICATION**

(43) Date of publication:
24.09.2025 Bulletin 2025/39

(21) Application number: 25163888.8

(22) Date of filing: 14.03.2025

(51) International Patent Classification (IPC):
$G01N\ 27/02^{(2006.01)}$    $G01N\ 27/416^{(2006.01)}$

(52) Cooperative Patent Classification (CPC):
G01N 27/028; G01N 27/4165; G01R 27/22;
G01N 27/36

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 19.03.2024 JP 2024043959

(71) Applicant: Yokogawa Electric Corporation
Tokyo 180-8750 (JP)

(72) Inventor: KYAKUNO, Toshihiko
Musashino-shi, Tokyo, 180-8750 (JP)

(74) Representative: Stöckeler, Ferdinand et al
Schoppe, Zimmermann, Stöckeler
Zinkler, Schenk & Partner mbB
Patentanwälte
Radlkoferstrasse 2
81373 München (DE)

(54) **MEASUREMENT APPARATUS AND MEASUREMENT METHOD**

(57) The impedance of an electrode can be measured more simply and accurately, in a pH measurement apparatus using a glass electrode. A measurement apparatus (10) includes a measurement unit (161) that measures the impedance of an electrode to be measured having first and second terminals, and a controller (11). The measurement unit (161) includes an operational amplifier having first and second input terminals and an output terminal, and a feedback resistor, which is a variable resistor, having a third terminal connected to the output terminal, and a fourth terminal connected to the first input terminal. The controller (11) acquires, in a state of the first input terminal connected to the first terminal, a measurement value of the impedance of the electrode to be measured, based on a voltage applied to the second terminal, the potential of the output terminal, and a resistance value of the feedback resistor.

## FIG. 6

EP 4 621 399 A1

**Description**

CROSS-REFERENCE TO RELATED APPLICATION

This application claims priority to Japanese Patent Application No. 2024-043959, filed on March 19, 2024, the entire contents of which are incorporated herein by reference.

TECHNICAL FIELD

The present disclosure relates to a measurement apparatus and a measurement method.

BACKGROUND

Hydrogen ion exponent (pH) is a physical quantity that indicates the degree of acidity or alkalinity of solutions. The pH is defined as the negative common logarithm of a hydrogen ion concentration in a solution.
A pH measurement method using a glass electrode is known as a method of measuring the pH of a solution. When two different solutions are present on both sides of a special glass membrane, an electromotive force proportional to a difference in pH between the two solutions is generated in the glass membrane. The pH measurement method using a glass electrode is a method of measuring the pH of a solution by measuring a potential difference that occurs between the glass electrode and a reference electrode due to such an electromotive force.
In pH measurement apparatuses using glass electrodes, impedance values of the electrodes vary due to deterioration of the electrodes, which reduces pH measurement accuracy. Patent Literature (PTL) 1 describes technology related to calibration of pH measurement values based on measurement values of the impedance of electrodes.

CITATION LIST

Patent Literature

PTL 1: JP 2013-019804 A

SUMMARY

However, conventional configuration has room for improvement in terms of measuring the impedance of an electrode simply and accurately.
It would be helpful to enable the impedance of an electrode to be measured more simply and accurately in a pH measurement apparatus using a glass electrode.

 (1) A measurement apparatus according to some embodiments includes:

  a measurement unit configured to measure the impedance of an electrode to be measured having first and second terminals; and
  a controller,
  wherein
  the measurement unit includes:

   an operational amplifier having first and second input terminals and an output terminal; and
   a feedback resistor that is a variable resistor having a third terminal connected to the output terminal, and a fourth terminal connected to the first input terminal, and

   the controller is configured to acquire, in a state of the first input terminal connected to the first terminal, a measurement value of the impedance of the electrode to be measured, based on a voltage applied to the second terminal, the potential of the output terminal, and a resistance value of the feedback resistor.

As described above, the measurement apparatus includes the feedback resistor, which is the variable resistor, of the operational amplifier, and acquires the measurement value of the impedance of the electrode to be measured, based on the voltage applied to the second terminal of the electrode to be measured, the potential of the output terminal of the operational amplifier, and the resistance value of the feedback resistor. Accordingly, the measurement apparatus can carry out the measurement by adjusting the resistance value of the feedback resistor according to the impedance of the electrode to be measured, and therefore can measure the impedance of the electrode to be measured simply and accurately. For example, even when the impedance of the electrode to be measured is extremely high, the measurement apparatus can measure the impedance of the electrode to be measured with high accuracy by increasing the resistance value of the feedback resistor according to the impedance.

In one embodiment,

(2) the measurement apparatus according to (1) may further include:

　　　a first switch configured to switch a terminal connected to the first input terminal and the fourth terminal, between a state of connecting to the first terminal and a state of not connecting to the first terminal; and

　　　a second switch configured to switch a terminal connected to the second input terminal, between a state of connecting to an electromotive force terminal that outputs the potential of the electrode to be measured immersed in a measurement solution, which is a sample, and a state of not connecting to the electromotive force terminal, wherein the controller may be configured to acquire the measurement value of the impedance of the electrode to be measured, in a state of the first switch connecting the first input terminal and the fourth terminal to the first terminal, and the second switch not connecting the second input terminal to the electromotive force terminal.

As described above, the measurement apparatus includes the first and second switches, and is switched, by switching these switches, between a pH measurement mode for measuring the pH of the measurement solution and an impedance measurement mode for measuring the impedance of the electrode to be measured. Therefore, the measurement apparatus that measures the pH of the measurement solution can also measure the impedance of the electrode to be measured with high accuracy, only by switching the switches.

In one embodiment,

(3) in the measurement apparatus according to (2), the controller may be configured to:

　　　acquire the potential of the electrode to be measured, in a state of the first switch not connecting the first input terminal and the fourth terminal to the first terminal, and the second switch connecting the second input terminal to the electromotive force terminal; and

　　　acquire the pH of the measurement solution based on the acquired potential of the electrode to be measured.

Therefore, the measurement apparatus can measure the pH of the measurement solution and the impedance of the electrode to be measured in a compact configuration.

In one embodiment,

(4) in the measurement apparatus according to any one of (1) to (3), the controller may be configured to:

　　　acquire the temperature of the electrode to be measured; and

　　　correct, based on the acquired temperature, the measurement value of the impedance of the electrode to be measured.

As described above, the measurement apparatus corrects the measurement value of the impedance of the electrode to be measured, based on the temperature of the electrode to be measured, and therefore can measure the impedance of the electrode to be measured with even higher accuracy.

In one embodiment,

(5) in the measurement apparatus according to (4), the controller may be configured to:

　　　acquire a temperature correction function that indicates a relationship between temperature and impedance according to the type of electrode to be measured; and

　　　correct, using the temperature correction function, the measurement value of the impedance of the electrode to be measured.

As described above, the measurement apparatus corrects the measurement value of the impedance, using the temperature correction function according to the type of electrode to be measured, and therefore can measure the impedance of the electrode to be measured with even higher accuracy.

In one embodiment,

(6) the measurement apparatus according to any one of (1) to (5) may further include a liquid ground circuit configured to apply a voltage to a glass electrode and a reference electrode via a measurement solution, wherein the measurement unit may include first and second measurement units, in a state of the liquid ground circuit applying the voltage, the first measurement unit being configured to measure the impedance of the glass electrode as the electrode to be measured, and the second measurement unit being configured to measure the impedance of the reference electrode as the electrode to be measured.

As described above, the measurement apparatus includes the first measurement unit that measures the impedance of the glass electrode and the second measurement unit that measures the impedance of the reference electrode in the state of the liquid ground circuit applying the voltage. Therefore, the measurement apparatus can measure the impedances of the glass electrode and the reference electrode with high accuracy.

In one embodiment,

(7) in the measurement apparatus according to (6), the controller may be configured to acquire the pH of the measurement solution based on a potential difference between the glass electrode and the reference electrode immersed in the measurement solution, in a state of the liquid ground circuit not applying the voltage.

As described above, the measurement apparatus can measure the pH of the measurement solution based on the potential difference between the glass electrode and the reference electrode immersed in the measurement solution, in the state of the liquid ground circuit not applying the voltage, and therefore can measure the pH of the measurement solution with high accuracy.

In one embodiment,

(8) in the measurement apparatus according to (7), the controller may be configured to correct, based on a correlation between variation in a measurement value of the impedance of the glass electrode and variation in a measurement value of the pH of the measurement solution, the pH of the measurement solution acquired based on the potential difference between the glass electrode and the reference electrode immersed in the measurement solution.

As described above, the measurement apparatus corrects the measurement value of the pH, based on the correlation between variation in the measurement value of the impedance of the glass electrode and variation in the measurement value of the pH of the measurement solution. Therefore, the measurement apparatus can measure the pH of the measurement solution with the highest possible accuracy, even when deterioration of the glass electrode has proceeded.

In one embodiment,

(9) in the measurement apparatus according to any one of (1) to (8), the measurement unit may include, as the feedback resistor, a resistor whose resistance value is switchable among multiple ranges.

Therefore, the measurement apparatus can carry out the measurement by switching the range of the resistance value of the feedback resistor according to the impedance of the electrode to be measured, and therefore can measure the impedance of the electrode to be measured simply and accurately.

In one embodiment,

(10) in the measurement apparatus according to any one of (1) to (9), the controller may be configured to:

acquire the degree of deterioration of the electrode to be measured, based on the measurement value of the impedance of the electrode to be measured; and
output the acquired degree of deterioration.

As described above, the measurement apparatus automatically outputs the degree of deterioration of the electrode to be measured, so a user can recognize the degree of deterioration of the electrode to be measured without having to measure the impedance individually for each measurement apparatus. The measurement apparatus measures the impedance of the electrode to be measured with high accuracy, and therefore can correctly acquire the degree of deterioration.

In one embodiment,

(11) in the measurement apparatus according to (10), the controller may be configured to:

predict timing of replacing the electrode to be measured, based on the degree of deterioration acquired at multiple points in time; and
output the predicted timing of replacing the electrode to be measured.

As described above, the measurement apparatus predicts and outputs the timing of replacing the electrode to be measured, based on the degree of deterioration of the electrode to be measured, so the user can take measures, if necessary, such as replacing the electrode to be measured in advance at appropriate timing before the electrode to be measured fails. The measurement apparatus measures the impedance of the electrode to be measured with high accuracy, and therefore can predict and output the timing of replacing the electrode to be measured.

A measurement method according to some embodiments is

(12) a measurement method by a measurement apparatus including:

a measurement unit configured to measure the impedance of an electrode to be measured having first and second terminals; and
a controller,
wherein
the measurement unit includes:

an operational amplifier having first and second input terminals and an output terminal; and
a feedback resistor that is a variable resistor having a third terminal connected to the output terminal, and a fourth terminal connected to the first input terminal, and

the controller is configured to acquire, in a state of the first input terminal connected to the first terminal, a measurement value of the impedance of the electrode to be measured, based on a voltage applied to the second terminal, the potential of the output terminal, and a resistance value of the feedback resistor.

The measurement method acquires, in the measurement apparatus including the feedback resistor, which is the variable resistor, of the operational amplifier, the measurement value of the impedance of the electrode to be measured, based on the voltage applied to the second terminal of the electrode to be measured, the potential of the output terminal of the operational amplifier, and the resistance value of the feedback resistor. Accordingly, the measurement method can carry out the measurement by adjusting the resistance value of the feedback resistor according to the impedance of the electrode to be measured, and therefore can measure the impedance of the electrode to be measured simply and accurately. For example, even when the impedance of the electrode to be measured is extremely high, the measurement method can measure the impedance of the electrode to be measured with high accuracy by increasing the resistance value of the feedback resistor according to the impedance.

According to an embodiment of the present disclosure, it is possible to measure the impedance of an electrode more simply and accurately in a pH measurement apparatus using a glass electrode.

BRIEF DESCRIPTION OF THE DRAWINGS

In the accompanying drawings:

FIG. 1 is a diagram illustrating a configuration of an impedance measurement circuit according to a comparative example;
FIG. 2 is a block diagram illustrating a configuration example of a measurement apparatus according to an embodiment;
FIG. 3 is a schematic diagram illustrating a configuration example of a measurement unit in FIG. 2;
FIG. 4 is a diagram illustrating a configuration example of a pH measurement circuit according to the embodiment;
FIG. 5 is a diagram illustrating a configuration example of the pH measurement circuit according to the embodiment;
FIG. 6 is a diagram illustrating a configuration example of an impedance measurement circuit according to the embodiment;
FIG. 7 is a diagram illustrating a configuration example of the impedance measurement circuit according to the embodiment;
FIG. 8 is a diagram illustrating a configuration example of a circuit equivalent to the impedance measurement circuit in FIG. 7;
FIG. 9 is a diagram illustrating an example of resistance values of a variable resistor according to switching of switches;
FIG. 10 is a diagram illustrating a configuration example of a hybrid circuit according to the embodiment;
FIG. 11 is a diagram illustrating a configuration example of a measurement circuit in FIG. 3;
FIG. 12 is a graph illustrating the schematic relationship between the temperature of an electrode and the impedance thereof;
FIG. 13 is a diagram illustrating a configuration example of a measurement system according to the embodiment;
FIG. 14 is a block diagram illustrating a configuration example of a server apparatus in FIG. 13;
FIG. 15 is a block diagram illustrating a configuration example of a terminal apparatus in FIG. 13;
FIG. 16 is a flowchart illustrating an example of operations of a measurement apparatus in FIG. 13;
FIG. 17 is a flowchart illustrating an example of operations of the measurement apparatus in FIG. 13; and
FIG. 18 is a flowchart illustrating an example of operations of the measurement apparatus in FIG. 13.

DETAILED DESCRIPTION

<Comparative Example>

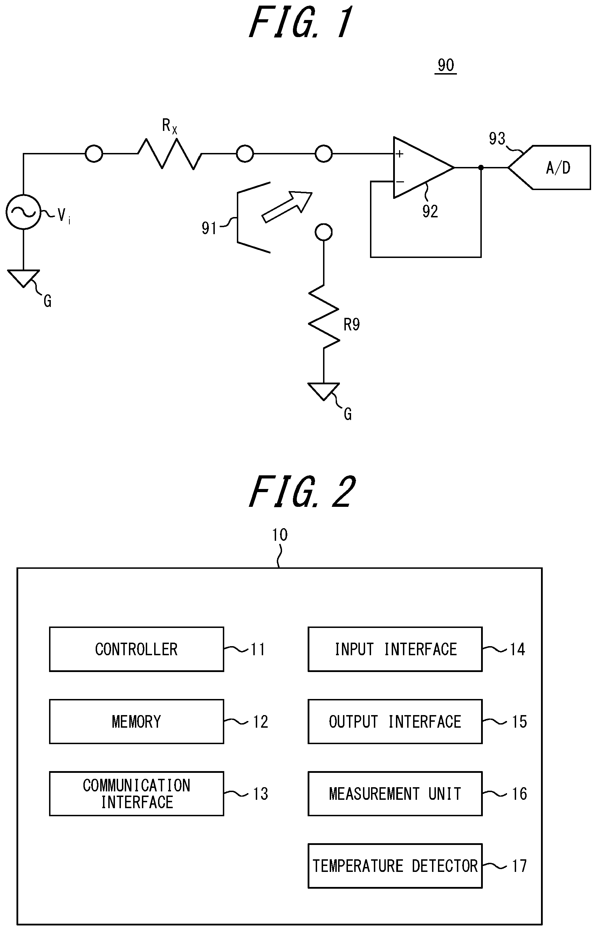

FIG. 1 is a diagram illustrating a configuration of an impedance measurement circuit 90 according to a comparative example. The impedance measurement circuit 90 measures the impedance of an electrode $R_x$ to be measured in a pH measurement apparatus using a glass electrode. The impedance measurement circuit 90 includes a resistor R9, an operational amplifier 92, and an analog-to-digital (A/D) converter 93. As illustrated in FIG. 1, the resistor R9, one end of which is connected to a ground G, is connected to an input terminal of the operational amplifier 92 by a jumper (short bar) 91. The resistor $R_x$, to which a voltage $V_i$ is applied, is also connected to the input terminal of the operational amplifier 92. An output terminal of the operational amplifier 92 is connected to the A/D converter 93, which outputs a current signal I converted into a digital signal. The impedance measurement circuit 90 acquires, based on the voltage $V_i$ and the current signal I, the impedance of the resistor $R_x$ as the electrode to be measured.

In the operational amplifier 92, an imaginary short is achieved so that the potential difference between the noninverting input terminal and the inverting input terminal is 0 V, and in a balanced state, a current input to the noninverting input terminal is 0. Therefore, a current $I_1$ flowing through the electrode $R_x$ to be measured and the resistor R9 is calculated using Equation (1).

$$I_1 = V_i / (R_x + R9) \qquad\qquad (1)$$

The voltage $V_2$ of the noninverting input terminal of the operational amplifier 92 is calculated using Equation (2).

$$V_2 = R9 \times I_1 \qquad\qquad (2)$$

Substituting Equation (1) into Equation (2) and solving for $R_x$ gives Equation (3).

$$R_x = (V_i / V_2 - 1) \times R9 \qquad\qquad (3)$$

In such a configuration, when the resistance value of the resistor R9 is extremely small compared to the impedance of the electrode $R_x$ to be measured, the value of $V_2$ input to the A/D converter 93 is extremely small, which makes it difficult to calculate the value of $V_2$ with high accuracy, due to rounding associated with digitization. Therefore, in order to measure the impedance of the resistor $R_x$ with high accuracy, it is necessary to connect the resistor R9 of a similar resistance value to the resistor $R_x$. However, the impedance of the resistor $R_x$ is unknown, so the resistance value of the connected resistor R9 may greatly differ from the impedance of the resistor $R_x$. When the resistance value of the resistor R9 greatly differs from the impedance of the resistor $R_x$, the impedance of the resistor $R_x$ cannot be measured with high accuracy.

In particular, the impedances of glass electrodes are generally in the range of several tens of M$\Omega$, to several G$\Omega$, and resistors with such high resistances are generally expensive. Accordingly, it is practically difficult to adopt the impedance measurement circuit 90 with the resistor R9 having a resistance value of several tens of M$\Omega$ to several G$\Omega$, as a module or the like included in the pH measurement apparatus. As a result, the measurement of the impedance of a glass electrode generally uses a high insulation resistance meter individually for each pH measurement apparatus, which requires a lot of effort for the maintenance of the pH measurement apparatus.

In addition, the impedance measurement circuit 90 according to the comparative example requires the resistor R9 to be connected with the jumper 91. Therefore, the management of the jumper 91 is troublesome.

As described above, the impedance measurement circuit 90 according to the comparative example has room for improvement in terms of measuring the impedance of the electrode $R_x$ to be measured, simply and accurately. As a result, there are problems with reliably implementing maintenance in a system with multiple pH measurement apparatuses. For example, it is difficult to reliably detect and respond to deterioration of the electrode $R_x$ to be measured, based on a variation in the impedance of the electrode $R_x$ to be measured.

<Embodiment>

The present disclosure describes a configuration example that can measure the impedance of an electrode to be measured simply and accurately. An embodiment of the present disclosure will be described below with reference to the drawings. In the drawings, components with the same configurations or functions are indicated with the same reference numerals. In the description of the present embodiment, duplicated description of the same components may be omitted or simplified as appropriate.

FIG. 2 is a block diagram illustrating a configuration example of a measurement apparatus 10 according to the embodiment. The measurement apparatus 10 measures the pH of a measurement solution, which is a sample. As illustrated in FIG. 2, the measurement apparatus 10 includes a controller 11, a memory 12, a communication interface 13, an input interface 14, an output interface 15, a measurement unit 16, and a temperature detector 17.

The controller 11 includes one or more processors. In the embodiment, the "processors" are general-purpose processors or dedicated processors specialized for specific processing, but are not limited to these. The controller 11 is communicably connected to each component of the measurement apparatus 10, and controls operations of the entire measurement apparatus 10.

The memory 12 includes any memory module, such as a hard disk drive (HDD), a solid state drive (SSD), a read-only memory (ROM), and a random access memory (RAM), for example. The memory 12 may function as a main memory device, an auxiliary memory device, or cache memory, for example. The memory 12 stores any information to be used for the operations of the measurement apparatus 10. For example, the memory 12 may store a system program, measurement data, a temperature correction function for each type of electrode, and various types of information received by the communication interface 13. The memory 12 is not limited to one built in the measurement apparatus 10, and may be an external database or an external memory module.

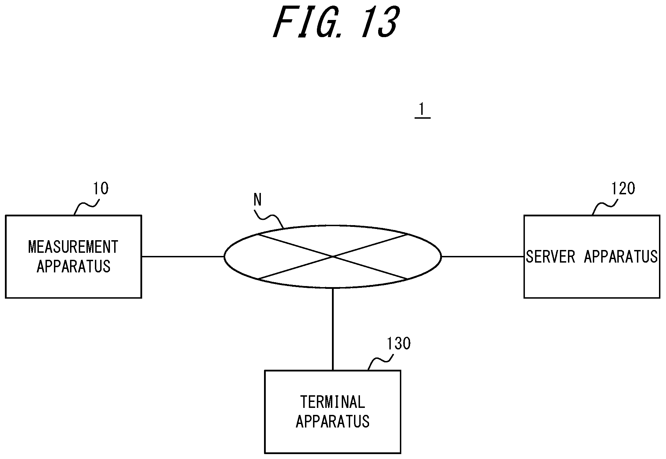

The communication interface 13 includes any communication module that can be communicably connected to other apparatuses such as a server apparatus 120 and a terminal apparatus 130 (see FIG. 13) using any communication technology. The communication interface 13 may further include a communication control module to control communication with other apparatuses and a memory module to store communication data such as identification information required for communication with the other apparatuses.

The input interface 14 includes one or more input interfaces that accept input operations from an operator and acquire input information based on the operations of the operator. The input interface 14 is, for example, a physical key, capacitive keys, a pointing device, a touch screen that are integrally provided with a display of the output interface 15, and the like, but is not limited to these.

The output interface 15 includes one or more output interfaces that output information to the operator and notify the operator. For example, the output interface 15 is, for example, a display that outputs information as images, a speaker that outputs information as audio, or the like, but is not limited to these. Such a display may be, for example, a liquid crystal panel display, an organic electro luminescence (EL) display, or the like. Furthermore, at least one of the above-described input interface 14 or output interface 15 may be configured integrally with the measurement apparatus 10, or may be provided separately.

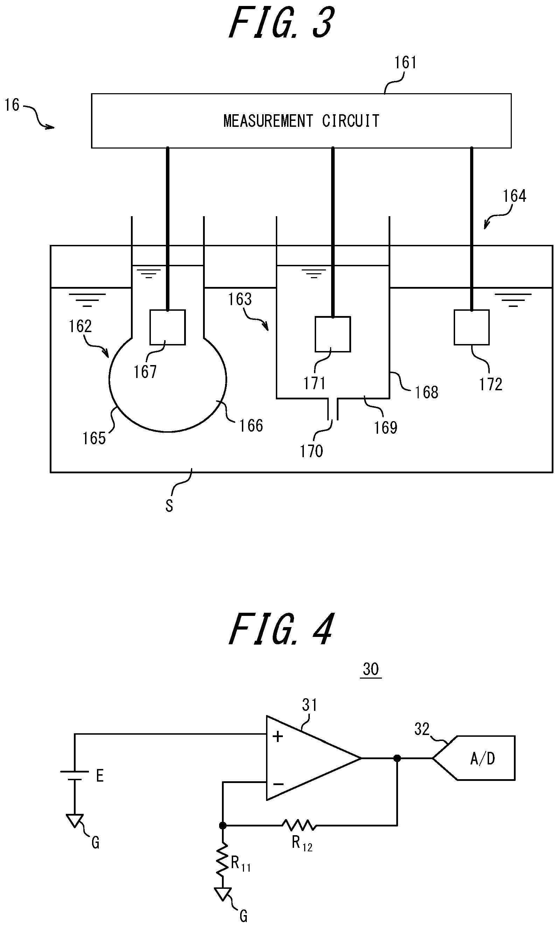

The measurement unit 16 measures the pH of the measurement solution, which is the sample, using a glass electrode 162. The details of the measurement unit 16 will be described later with reference to FIGS. 3 to 11.

The temperature detector 17 detects the temperatures of the glass electrode 162 and a reference electrode 163 (see FIG. 3) as described later. The temperature detector 17 is constituted of a thermistor or thermocouple, but the principle of the temperature detector 17 is arbitrary.

The functions of the measurement apparatus 10 can be realized by executing a computer program (program) according to the present embodiment on a processor included in the controller 11. In other words, the functions of the measurement apparatus 10 can be realized by software. The computer program causes a computer to execute processing of steps included in the operations of the measurement apparatus 10, thereby causing the computer to realize a function corresponding to processing of each step. In other words, the computer program is a program to cause the computer to function as the measurement apparatus 10 according to the present embodiment.

Some or all of the functions of the measurement apparatus 10 may be implemented by dedicated circuitry included in the controller 11. In other words, all or some of the functions of the measurement apparatus 10 may be implemented by hardware. The measurement apparatus 10 may be implemented by a single computer, or may be implemented by the cooperation of multiple computers.

FIG. 3 is a schematic diagram illustrating a configuration example of the measurement unit 16 in FIG. 2. As illustrated in FIG. 3, the measurement unit 16 includes a measurement circuit 161, the glass electrode 162, the reference electrode 163, and a liquid ground 164. The glass electrode 162, the reference electrode 163, and the liquid ground 164 are immersed in a measurement solution S, which is a sample.

The measurement circuit 161 is connected to the glass electrode 162, the reference electrode 163, and the liquid ground 164. The measurement circuit 161 measures, based on the potentials of the glass electrode 162, the reference electrode 163, and the liquid ground 164, the pH of the measurement solution S and the impedances of the glass electrode 162 and the reference electrode 163.

The glass electrode 162 includes a glass membrane 165, a buffer solution 166 contained in the glass membrane 165, and an electrode 167. The buffer solution 166 is a liquid whose pH is known in advance. The pH of the buffer solution 166 is 7, for example. When the glass membrane 165 that contains such a buffer solution 166 is immersed in the measurement solution S, an electromotive force proportional to the difference in pH between the buffer solution 166 and the measurement solution S is generated on a surface of the glass membrane 165. The electrode 167 is used to detect such an electromotive force. The electrode 167 is immersed in the buffer solution 166.

The reference electrode 163 is an electrode as a reference to detect the electromotive force generated on the surface of the glass membrane 165. The reference electrode 163 includes a container 168 provided with a liquid junction 170, a KCl solution (e.g., 3.3 M KCl) 169 contained in the container 168, and an electrode 171. The liquid junction 170 may be made of porous ceramic, for example. The KCl solution 169 flows out through the liquid junction 170 and contacts the measurement solution S. The reference electrode 163 can thereby obtain a constant reference potential with respect to the measurement solution S, regardless of variations in the properties of the measurement solution S, such as temperature, pressure, and flow rate. The electrode 171 is immersed in the KCl solution 169.

Generally, the electromotive force generated on the surface of the glass membrane 165 is measured from the potential of the electrode 167 and the potential of the electrode 171, and the pH of the measurement solution S is measured according to the electromotive force. In contrast, the measurement unit 16 further includes the liquid ground 164 having an electrode 172 immersed in the measurement solution S. The measurement unit 16 acquires the potential of the glass electrode 162 with respect to the liquid ground 164 and the potential of the reference electrode 163 with respect to the liquid ground 164, and measures the electromotive force generated on the surface of the glass membrane 165 using the difference therebetween. Therefore, the measurement apparatus 10 according to the present embodiment can measure the pH of the measurement solution S with high accuracy.

On the other hand, the measurement circuit 161 measures the impedance of the glass electrode 162, in a state of the glass electrode 162 and the liquid ground 164 immersed in the measurement solution S. Specifically, the measurement circuit 161 measures the potential difference between the electrodes 167 and 172 via the measurement solution S, and measures the impedance of the glass electrode 162 based on the measurement value of the potential difference. The measurement circuit 161 measures the impedance of the reference electrode 163 in a state of the reference electrode 163 and the liquid ground 164 immersed in the measurement solution S. Specifically, the measurement circuit 161 measures the potential difference between the electrodes 171 and 172 via the measurement solution S, and measures the impedance of the reference electrode 163 based on the measurement value of the potential difference.

The impedance of the glass electrode 162 is several tens of $M\Omega$ to several $G\Omega$. In contrast, the impedance of the measurement solution S is negligibly low. Therefore, the measurement unit 16 can measure the impedance of the glass electrode 162 via the measurement solution S. The impedance of the reference electrode 163 is several $k\Omega$ to several hundreds of $k\Omega$. Therefore, the measurement apparatus 10 may separately measure the impedance of the measurement solution S, i.e., the conductivity of the measurement solution S, and measure the impedance of the reference electrode 163 by subtracting the impedance of the measurement solution S from an impedance measured via the reference electrode 163 and the measurement solution S.

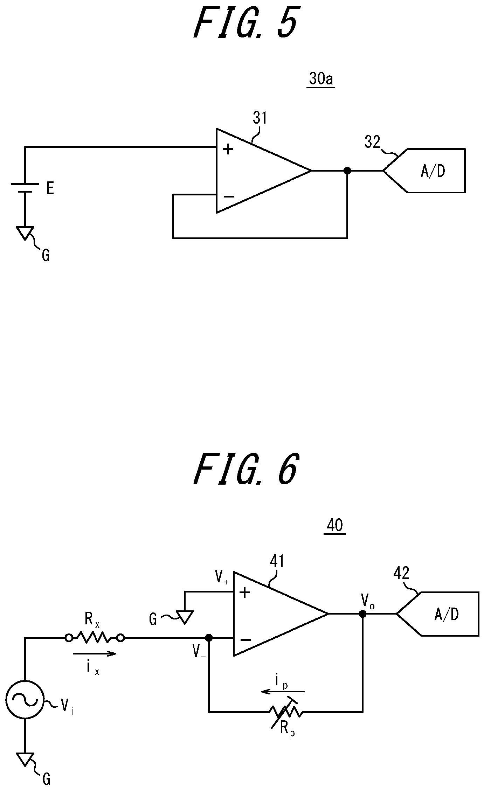

Next, a pH measurement circuit 30 to measure the pH of the measurement solution S will be described with reference to FIGS. 4 and 5. FIG. 4 is a diagram illustrating a configuration example of the pH measurement circuit 30 according to the embodiment. As illustrated in FIG. 4, the pH measurement circuit 30 includes an operational amplifier 31, an A/D converter 32, a resistor R11, and a resistor R12. FIG. 4 illustrates the pH measurement circuit 30 configured as a noninverting amplifier circuit, but the pH measurement circuit 30 is not limited to a noninverting amplifier circuit as long as the pH measurement circuit 30 can convert a signal of a voltage source with an extremely high impedance into a voltage without attenuation. For example, the pH measurement circuit 30 may be configured as an inverting amplifier circuit or as a voltage follower circuit (see FIG. 5).

The operational amplifier 31 has two input terminals (noninverting input terminal and inverting input terminal) and an output terminal. To the noninverting input terminal (positive input terminal) as a second input terminal, a voltage E based on the electromotive force is applied. The terminal to which the potential of an electrode to be measured immersed in the measurement solution, which is a sample, is output is also referred to as an "electromotive force terminal." The resistor R12, as a feedback resistor, is connected between the inverting input terminal (negative input terminal), as a first input terminal, and the output terminal. The inverting input terminal is connected to a ground G via the resistor R11. The output terminal is connected to the A/D converter 32, and output of the operational amplifier 31 is output as a digital signal.

In such a configuration, an output voltage Vout of the operational amplifier 31 is $(1 + R12 / R11) E$. In other words, the amplification factor of the pH measurement circuit 30 is $(1 + R12 / R11)$. Therefore, dividing the output voltage Vout, which is output from the A/D converter 32 as the digital signal, by the amplification factor allows acquisition of the voltage E based on the electromotive force. Since it is known that there is a certain relationship between the voltage E based on the electromotive force and the pH, the pH can be acquired based on the voltage E. In the present embodiment, the potential $E_1$ of the glass electrode 162 based on the liquid ground 164 and the potential $E_2$ of the reference electrode 163 based on the liquid ground 164 are acquired, and the pH is acquired according to the difference $(E_1 - E_2)$ therebetween.

FIG. 5 illustrates a configuration example of a pH measurement circuit 30a configured as a voltage follower circuit. As illustrated in FIG. 5, in the configuration example of the pH measurement circuit 30a configured as a voltage follower circuit, the output terminal of the operational amplifier 31 and the inverting input terminal (negative input terminal) are directly connected.

Next, an impedance measurement circuit 40 to measure the impedance of an electrode to be measured will be described with reference to FIG. 6. FIG. 6 is a diagram illustrating a configuration example of the impedance measurement circuit 40 according to the embodiment. As illustrated in FIG. 6, the impedance measurement circuit 40 includes an operational amplifier 41, an A/D converter 42, a feedback resistor (variable resistor) $R_p$, and a voltage source $V_i$. The impedance measurement circuit 40 measures the impedance of an electrode $R_x$ to be measured, which has first and second terminals.

The operational amplifier 41 includes two input terminals (noninverting input terminal and inverting input terminal) and an output terminal. The noninverting input terminal, as a second input terminal, is connected to a ground G. The feedback resistor $R_p$ is connected between the inverting input terminal, as a first input terminal, and the output terminal. The feedback resistor $R_p$ has third and fourth terminals, and the output terminal of the operational amplifier 41 is connected to the third terminal, while the inverting input terminal is connected to the fourth terminal. The output terminal is connected to the A/D converter 42, and output of the operational amplifier 41 is output as a digital signal.

The impedance measurement circuit 40 measures the unknown impedance of the electrode $R_x$ to be measured, by applying a known voltage $V_i$ to the liquid ground 164 and measuring an output voltage $V_o$ of the operational amplifier 41 with respect to this voltage $V_i$. More specifically, the voltage $V_o$ is obtained from a current $i_x$ using the amplifier 41, and the impedance of the electrode $R_x$ to be measured is calculated from the voltage $V_o$, the resistance value of the feedback resistor $R_p$, and the voltage $V_i$. Therefore, the first terminal of the electrode (resistor $R_x$), to which the voltage $V_i$ is applied, is connected to the inverting input terminal of the operational amplifier 41.

Here, in the operational amplifier 41, an imaginary short is achieved so that the potential difference between the noninverting input terminal and the inverting input terminal is 0 V, so the potential $V_-$ of the inverting input terminal is equal to the potential $V_+ = 0$ of the noninverting input terminal. Therefore, the current $i_x$ flowing through the resistor $R_x$ toward the inverting input terminal of the operational amplifier 41 can be calculated using Equation (4).

$$i_x = (V_i - V_-) / R_x$$
$$= V_i / R_x \qquad (4)$$

On the other hand, a current $i_p$ flowing from the output terminal through the feedback resistor $R_p$ toward the inverting input terminal is calculated using Equation (5), based on the potential $V_o$ of the output terminal and the potential $V_-$ of the inverting input terminal.

$$i_p = (V_o - V_-) / R_p$$
$$= V_o / R_p \qquad (5)$$

Here, there is no current input or output at the inverting input terminal of the operational amplifier 41. Therefore, the total current is 0, and $i_x + i_p = 0$. Therefore, Equation (6) stands true.

$$i_x = - i_p \qquad (6)$$

By substituting Equations (4) and (5) into Equation (6), Equation (7) stands true.

$$V_i / R_x = - V_o / R_p \qquad (7)$$

By transforming Equation (7), Equation (8) stands true.

$$R_x = - (V_i / V_o) R_p \qquad (8)$$

Here, the minus sign in Equation (8) is due to the definition of the direction of the currents $i_p$ and $i_x$, and may be ignored.

Therefore, the impedance of the electrode to be measured can be calculated using Equation (8) based on the voltages $V_i$ and $V_o$ and the feedback resistor $R_p$. In FIG. 6, the applied voltage $V_i$ is indicated using an alternating current symbol, but may be a direct current voltage.

By transforming Equation (8), Equation (9) stands true.

$$V_o = - (R_p / R_x) V_i \qquad (9)$$

Therefore, when the difference in resistance between $R_p$ and $R_x$ is significant, the output voltage $V_o$ of the operational amplifier 41 exceeds the range of signal values that the A/D converter 42 or other components can process, which causes the impedance $R_x$ not to be measured with high accuracy. Therefore, the measurement unit 16 measures the impedance $R_x$ with high accuracy by setting the resistance value of the feedback resistor $R_p$ to a value close to $R_x$.

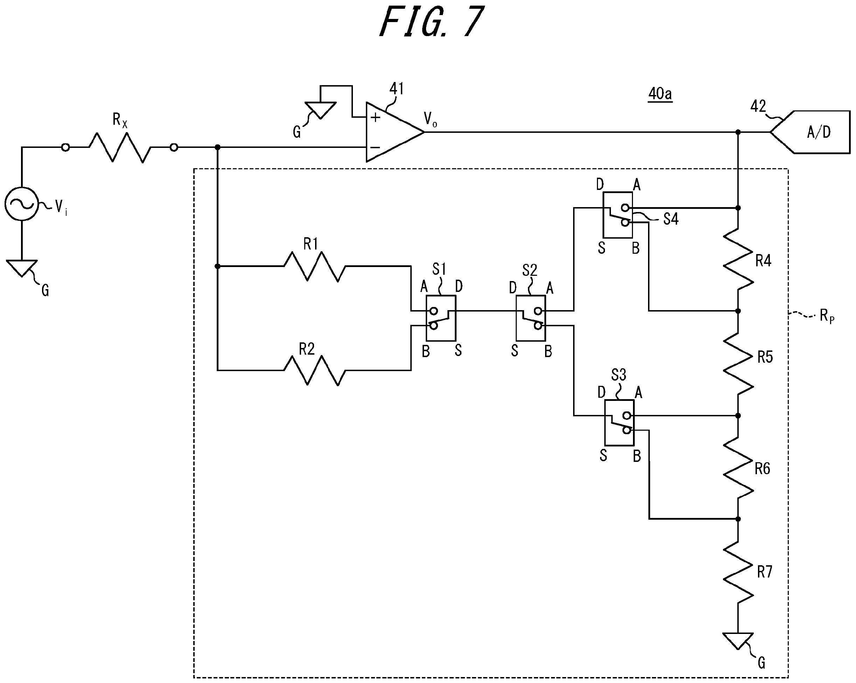

By connecting switches and resistors in a binary tree structure, the feedback resistor $R_p$ can achieve high resistance values using resistors with low resistance values. FIG. 7 is a diagram illustrating a configuration example of an impedance measurement circuit 40a according to the embodiment.

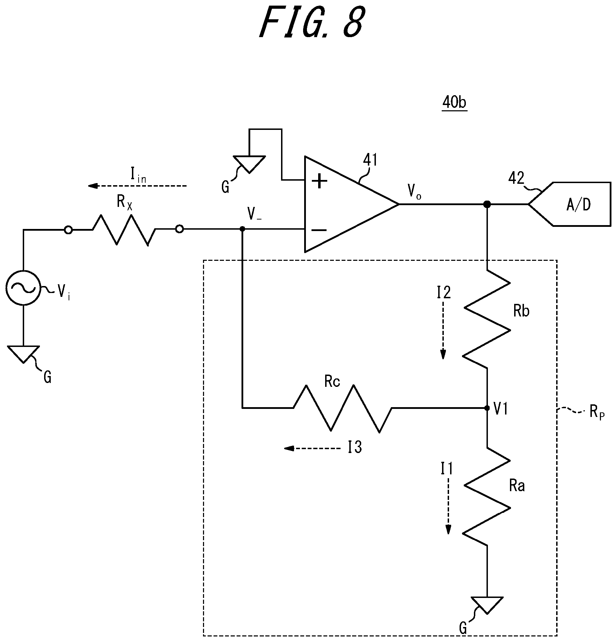

In FIG. 7, the feedback resistor $R_p$ includes resistors R1, R2, and R4 to R7 and switches S1 to S4. The resistors R1 and R2 are connected in parallel. Both the resistors R1 and R2 are connected to the inverting input terminal of the operational amplifier 41 at one end, and are connected to the switch S1 at the other end. The switch S1 is connected to the switch S2 at one end. The switch S1 can switch a circuit element connected to the switch S2 between the resistors R1 and R2. By switching the switch S1, the resistor R1 or R2 corresponds to a resistor Rc in FIG. 8.

The resistors R4 to R7 are connected in series in this order. An end of the resistor R4 that is not connected to the resistor R5 is connected to the output terminal of the operational amplifier 41. An end of the resistor R7 that is not connected to the resistor R6 is connected to a ground G.

The switch S2 is connected to the switch S1 at one end. The switch S2 can switch a circuit element connected to the switch S1 between the switches S4 and S3. The switch S4 can switch a circuit element connected to the switch S2 between both terminals of the resistor R4. The switch S3 can switch a circuit element connected to the switch S2 between both terminals of the resistor R6. By switching the switches S2, S3, and S4, one of a connection terminal between the operational amplifier 41 and the resistor R4, a connection terminal between the resistors R4 and R5, a connection terminal between the resistors R5 and R6, and a connection terminal between the resistors R6 and R7 is directly electrically connected to the switch S1. In other words, according to switching operations of the switches S2 to S4, the series of resistors R4 to R7 are divided into two parts by a contact point, which is connected directly to the switch S1, between the resistors, and operate as voltage dividing resistors Ra and Rb, except when the switch S1 is connected directly to the output terminal of the operational amplifier 41. Note that, the switches S1 to S4 are semiconductor or relay switches, but may be implemented by other methods.

The resistance value of the feedback resistor $R_p$ in the impedance measurement circuit 40a is determined by the resistance values of the resistors Ra, Rb, and Rc, which are determined by switching of the switches S1 to S4. The relationship between the resistance value of each of the voltage dividing resistors Ra and Rb and the resistor Rc and the resistance value of the feedback resistor $R_p$ will be described with reference to FIG. 8. FIG. 8 is a diagram illustrating a configuration example of a circuit 40b equivalent to the impedance measurement circuit 40a in FIG. 7.

In FIG. 8, the output terminal of the operational amplifier 41 is connected to an end of the resistor Rb. The other end of the resistor Rb is connected to an end of the resistor Ra, and also connected to an end of the resistor Rc. The other end of the resistor Rc is connected to the inverting input terminal of the operational amplifier 41, and forms a negative feedback circuit of the operational amplifier 41. The other end of the resistor Ra is connected to the ground G.

As illustrated in FIG. 8, the potential of the output terminal of the operational amplifier 41 is $V_o$. The potential of the inverting input terminal of the operational amplifier 41 is $V_-$. In the negative feedback circuit as illustrated in FIG. 8, a feedback signal follows an input signal, and as described above, in a steady state, the input signal and the feedback signal are in a so-called imaginary short state, as if the input signal and the feedback signal were shorted (short-circuited). In the imaginary short state, the potential difference between the potential $V_-$ of the inverting input terminal of the operational amplifier 41 and the potential (0 by grounding) of the noninverting input terminal is 0, so $V_- = 0$.

In the imaginary short state, current input and output at the inverting input terminal of the operational amplifier 41 is 0. Therefore, a current I3 flowing through the resistor Rc toward the inverting input terminal of the operational amplifier 41 is equal to a current $I_{in}$ flowing through the resistor $R_x$ of the electrode ($I_{in} = I3$). Therefore, a potential V1 at the connection terminal between the resistor Rb and the resistor Ra is Rc $\times$ I3 = Rc $\times$ $I_{in}$.

The potential $V_o$ of the output terminal of the operational amplifier 41 is expressed by the equation $V_o$ = V1 + Rb $\times$ I2, using a current I2 flowing from the output terminal to the resistor Rb, the resistance value of the resistor Rb, and the above V1. As described above, the relationship V1 = Rc $\times$ $I_{in}$ and the relationship I2 = I1 + I3 = I1 + $I_{in}$ stand true, so the relationship $V_o$ = Rc $\times$ $I_{in}$ + Rb $\times$ (I1 + $I_{in}$) stands true. Furthermore, the relationship I1 = V1 / Ra stands true. As described above, the relationship V1 = Rc $\times$ $I_{in}$ stands true, so the following Equation (10) stands true.

$$V_o = Rc \times I_{in} + Rb \times (V1 / Ra + I_{in})$$
$$= Rc \times I_{in} + Rb \times (Rc / Ra \times I_{in} + I_{in})$$
$$= I_{in} \times (Rc \times (1 + Rb / Ra) + Rb) \qquad (10)$$

Here, by transforming Equation (7), Equation (11) stands true.

$$R_p = - (V_o / V_i) R_x \qquad (11)$$

By substituting Equation (10) into Equation (11), the following Equation (12) stands true.

$$R_p = - (I_{in}R_y / V_i) R_x \qquad (12)$$

$R_y$ is given by Equation (13).

$$R_y = Rc \times (1 + Rb / Ra) + Rb \qquad (13)$$

Here, $I_{in} = - I_x$, and Equation (14) stands true from Equation (4).

$$I_{in} = - V_i / R_x \qquad (14)$$

By substituting Equation (14) into Equation (12), Equation (15) is obtained.

$$R_p = R_y$$
$$= Rc \times (1 + Rb / Ra) + Rb \qquad (15)$$

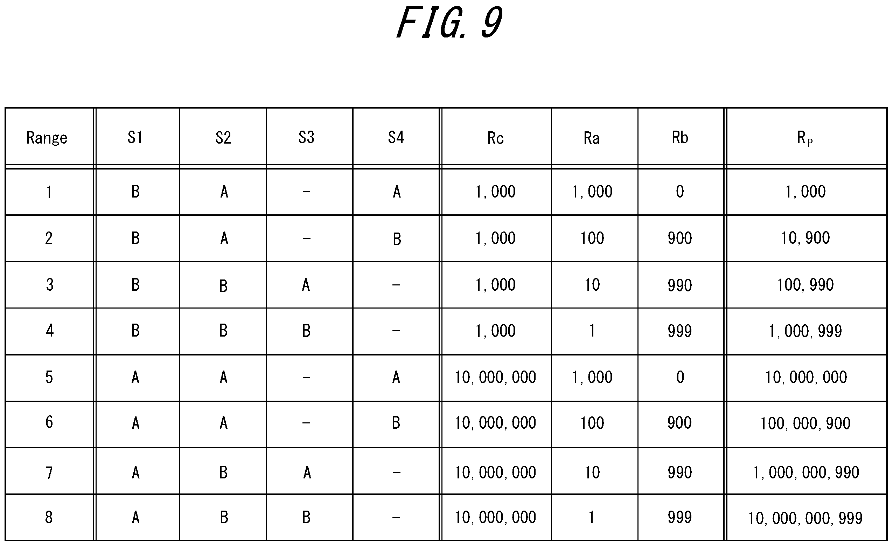

Here, assume that the resistor R1 is 10 MΩ, the resistor R2 is 1 kΩ, the resistor R4 is 900 Ω, the resistor R5 is 90 Ω, the resistor R6 is 9 Ω, and the resistor R7 is 1 Ω. In this case, the relationship between the connection relationship of the switches S1 to S4 and the resistance values of Ra, Rb, Rc, and $R_p$ are illustrated in FIG. 9. FIG. 9 is a diagram illustrating an example of the resistance values of the feedback resistor $R_p$ according to switching of the switches.

For example, when Range is set to "1", the switch S1 is set to "B", so the switch S1 connects the switch S2 to the resistor R2 (= 1 kΩ), which gives Rc = 1,000 Ω. The switch S2 is set to "A". The switch S4 is set to "A". Therefore, regardless of the setting of the switch S3, the voltage dividing resistor Ra is 1,000 Ω (= R4 + R5 + R6 + R7), and the voltage dividing resistor Rb is 0 Ω. Therefore, the feedback resistor $R_p$ is 1,000 Ω.

For example, when Range is set to "7", the switch S1 is set to "A", so the switch S1 is connected the switch S2 to the resistor R1 (= 10 MΩ), which gives Rc = 10,000,000 Ω. The switch S2 is set to "B". The switch S3 is set to "A". Therefore, regardless of the setting of the switch S4, the voltage dividing resistor Ra is 10 Ω (= R6 + R7), and the voltage dividing resistor Rb is 990 Ω (= R4 + R5). Therefore, the feedback resistor $R_p$ is 1,000,000,990 Ω.

As illustrated in FIG. 9, the resistance value of the feedback resistor $R_p$ can be switched in eight steps in a wide dynamic range of 1 k, 10 k, 100 k, 1 M, 10 M, 100 M, 1 G, and 10 G, by switching the switches S1, S2, S3, and S4. In the example described above, the feedback resistor $R_p$ includes only one resistor of 10 MΩ, i.e., the resistor R1. Only the four switches S1, S2, S3, and S4 are used. Therefore, the feedback resistor $R_p$ can achieve a wide dynamic range of $10^7$ times from a minimum resistance to a maximum resistance using a small number of high-resistance resistors and switches. Also, the feedback resistor $R_p$ has no switches that are connected in parallel and energized at the same time, so leakage currents generated in the switches do not accumulate and become a large error current. For example, the switches S3 and S4 are switched by the switch S2. Therefore, there are no occasions in which leakage currents accumulate due to energization of the switches S3 and S4 at the same time. Therefore, according to the feedback resistor $R_p$, a variable resistor with a large dynamic range, low cost, and simple configuration can be achieved. The impedance measurement circuit 40, which is provided with such a feedback resistor $R_p$, can measure the impedance of the glass electrode 162 and the reference electrode 163 with high accuracy over a wide dynamic range.

Furthermore, the configuration of the feedback resistor $R_p$ is not limited to the one explained with reference to FIG. 7. For example, in the feedback resistor $R_p$ in FIG. 7, the resistor Rc can be selected from among the two resistors R1 and R2, but the resistor Rc may be determined as a specific resistor or may be selected from among three or more resistors. Also, in the feedback resistor $R_p$ in FIG. 7, the four resistors R4 to R7 connected in series are divided into the voltage dividing resistors Ra and Rb using the switches S2 to S4, but the number of resistors may be three or less, or five or more. The feedback resistor $R_p$ in FIG. 7 has the three switches S2 to S4 connected in a binary tree structure to realize the voltage dividing resistors Ra and Rb, but the number of switches may be two or less, or four or more. In addition, the feedback resistor $R_p$ may have the same configuration as in the amplification circuits (for example, the feedback resistors in the amplification circuits illustrated in FIGS. 1, 3, 5, and 8 of the same publication) described in the publication of JP 2022-002384 A.

The measurement circuit 161 may be provided with the pH measurement circuit 30 or 30a, which is described with reference to FIG. 4 or 5, and the impedance measurement circuit 40, which is described with reference to FIGS. 6 to 9, individually for each of the glass electrode 162 and the reference electrode 163. Alternatively, the measurement circuit 161 may be provided with a hybrid circuit 50 that can switch between the pH measurement circuit 30 and the impedance measurement circuit 40 by switches, for each of the glass electrode 162 and the reference electrode 163.

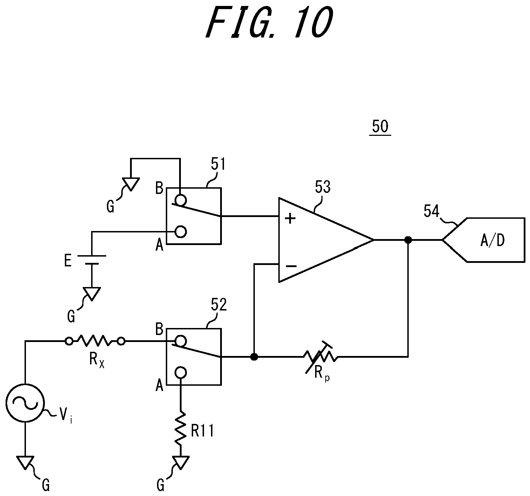

FIG. 10 is a diagram illustrating a configuration example of the hybrid circuit 50 according to the embodiment. As illustrated in FIG. 10, the hybrid circuit 50 includes switches 51 and 52, an operational amplifier 53, an A/D converter 54, a resistor R11, a feedback resistor (variable resistor) $R_p$, and a voltage source $V_i$.

As illustrated in FIG. 10, the switch 51 is connected to a noninverting input terminal, as a second input terminal, of the operational amplifier 53. The switch 51, as a second switch, can switch a circuit element connected to the noninverting input terminal between a ground G (set to "B") and an electrode to which a voltage E based on an electromotive force is applied (set to "A"). The feedback resistor $R_p$, as a feedback resistor, is connected between an inverting input terminal, as a first input terminal, and an output terminal of the operational amplifier 53. The output terminal is connected to the A/D converter 54, and output of the operational amplifier 53 is output as a digital signal. The inverting input terminal of the operational amplifier 53 is also connected to the switch 52. The switch 52, as a first switch, can switch a circuit element connected to the inverting input terminal, between an electrode to be measured with an impedance $R_x$, to which a known voltage $V_i$ applied to the liquid ground 164 is applied (set to "B"), and a resistor R11 the other end of which is connected to a ground G (set to "A"). Note that, the switches 51 and 52 are semiconductor or relay switches, but may be realized by other methods.

When the switches 51 and 52 are both set to "A", the hybrid circuit 50 is equivalent to the pH measurement circuit 30 illustrated in FIG. 4. When the switches 51 and 52 are both set to "B", the hybrid circuit 50 is equivalent to the impedance measurement circuit 40 illustrated in FIG. 6. The measurement circuit 161 can measure the potential and impedance based on the pH of each electrode by providing such a hybrid circuit 50 for each of the glass electrode 162 and the reference electrode 163.

Note that, in the configuration example illustrated in FIG. 10, the impedance measurement circuit 40 illustrated in FIG. 6 can be switched to the pH measurement circuit 30 illustrated in FIG. 4, but the hybrid circuit 50 may be switched to the pH measurement circuit 30a illustrated in FIG. 5, instead of the pH measurement circuit 30 illustrated in FIG. 4. In this case, the switch 52 may be switchable between a state in which the inverting input terminal of the operational amplifier 53 is connected to the electrode to be measured (set to "B") and a state in which the inverting input terminal of the operational amplifier 53 is not connected to any other circuit element (set to "A"). The feedback resistor $R_p$ may short the output terminal and the inverting input terminal of the operational amplifier 53. Furthermore, the hybrid circuit 50 may be configured to be able to switch the impedance measurement circuit 40 to a pH measurement circuit configured as an inverting amplification circuit.

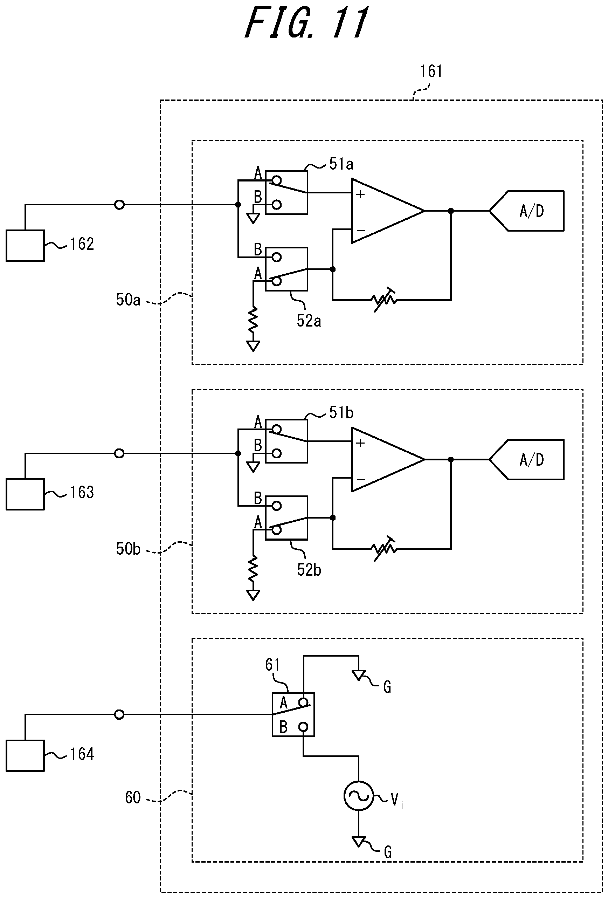

FIG. 11 is a configuration example of the measurement circuit 161 in FIG. 3. As illustrated in FIG. 11, the measurement circuit 161 includes hybrid circuits 50a and 50b and a liquid ground circuit 60. The hybrid circuit 50a is connected to the glass electrode 162. The hybrid circuit 50b is connected to the reference electrode 163. Each of the hybrid circuits 50a and 50b has the configuration described with reference to FIG. 10. The liquid ground circuit 60 is connected to the liquid ground 164. The liquid ground circuit 60 includes a switch 61. The switch 61 can switch a circuit element connected to the electrode 172 of the liquid ground 164 between a ground G (set to "A") and a voltage source $V_i$ (set to "B"). The switch 61 may be a semiconductor or relay switch, but may be realized by other methods. In FIG. 11, the applied voltage $V_i$ is indicated by an alternating current symbol, but may be a direct current voltage.

When the pH of the measurement solution S is measured, the measurement circuit 161 sets all of the switches 51 (51a, 51b), 52 (52a, 52b), and 61 to "A". When the impedances of the glass electrode 162 and the reference electrode 163 are measured, the measurement circuit 161 sets all the switches 51, 52, and 61 to "B". Due to the provision of such a measurement circuit 161, the measurement apparatus 10 can measure the pH of the measurement solution S and the impedance of the electrode to be measured simply and accurately in a compact configuration.

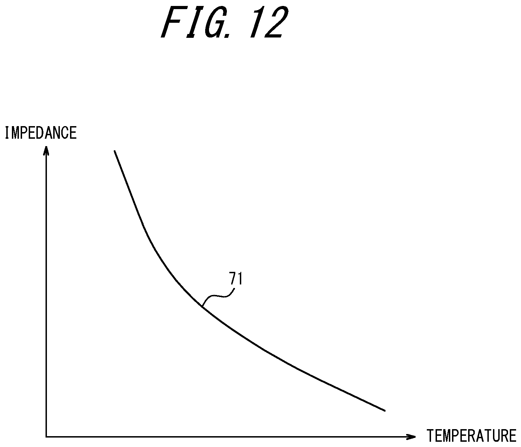

It is known that the impedance of the electrode to be measured varies according to the temperature of the electrode. FIG. 12 is a graph 71 illustrating the schematic relationship between the temperature of the electrode to be measured and the impedance thereof. In FIG. 12, the horizontal axis represents the temperature of the electrode. The vertical axis represents the impedance of the electrode on a logarithmic scale. The graph 71 represents the relationship between the temperature of the electrode and the impedance thereof. The graph 71 indicates that the impedance of the electrode decreases rapidly as the temperature increases. Therefore, when measuring the impedances of the glass electrode 162 and the reference electrode 163, the measurement apparatus 10 corrects measurement values of the impedances based on the temperatures of the electrodes measured by the temperature detector 17. Specifically, the measurement apparatus 10 may acquire a temperature correction function that indicates the relationship between temperature and impedance according to the type of electrode, and may correct the measurement value of the impedance using that temperature correction function. By performing such temperature correction, the measurement apparatus 10 can measure the impedance of the electrode to be measured with high accuracy.

The measurement apparatus 10 may transmit measurement results to the server apparatus 120 via a network N in a measurement system 1. The server apparatus 120 may manage the impedance of the electrode $R_x$ to be measured, deterioration of the electrode, and the like, for each measurement apparatus 10. Such a measurement system 1 will be described with reference to FIG. 13. FIG. 13 is a diagram illustrating a configuration example of the measurement system 1 according to the embodiment.

As illustrated in FIG. 13, the measurement system 1 includes the measurement apparatus 10, the server apparatus 120, and the terminal apparatus 130. The measurement apparatus 10, the server apparatus 120, and the terminal apparatus 130 are communicably connected to each other via any network N, including the Internet, intranet, or a combination of these. The numbers of measurement apparatuses 10, server apparatuses 20, and terminal apparatuses 130 are arbitrary, and may be two or more.

The server apparatus 120 manages the measurement results, such as the pH of the measurement solution S and the impedance of the electrode to be measured, by the measurement apparatus 10, as well as the deterioration status of the electrode. The server apparatus 120 is configured with any computer, e.g., a workstation (WS), a personal computer (PC), or the like.

The terminal apparatus 130 accesses the server apparatus 120 to acquire the measurement results and the deterioration status of the electrode managed by the measurement apparatus 10. The terminal apparatus 130 may be operated by a user including a maintenance worker of the measurement apparatus 10. The terminal apparatus 130 is configured with any computer, e.g., a PC, a tablet terminal, a smartphone, or the like.

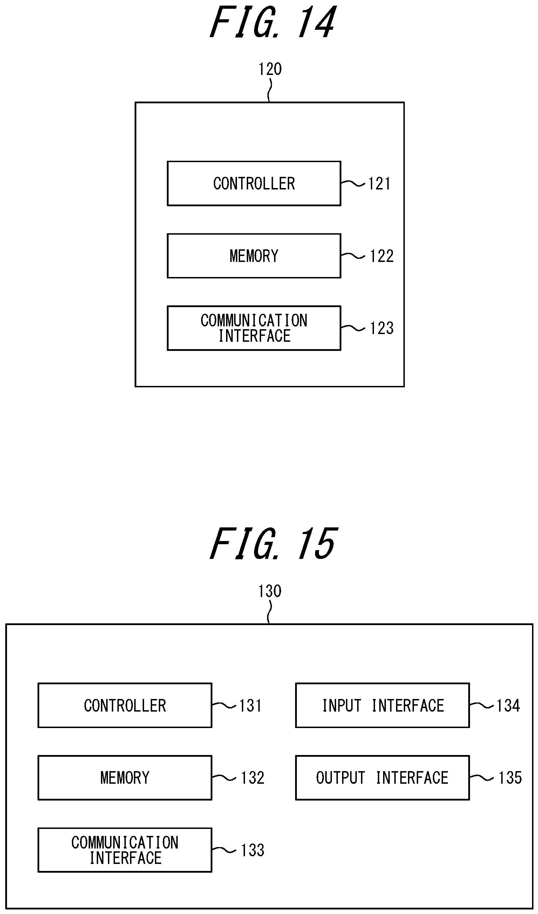

FIG. 14 is a block diagram illustrating a configuration example of the server apparatus 120 in FIG. 13. The server apparatus 120 includes a controller 121, a memory 122, and a communication interface 123. The configurations of the controller 121, the memory 122, and the communication interface 123 are the same as those of the controller 11, the memory 12, and the communication interface 13 of the measurement apparatus 10, so a detailed description is omitted.

FIG. 15 is a block diagram illustrating a configuration example of the terminal apparatus 130 in FIG. 13. The terminal apparatus 130 includes a controller 131, a memory 132, a communication interface 133, an input interface 134, and an output interface 135. The configurations of the controller 131, the memory 132, the communication interface 133, the input interface 134, and the output interface 135 are the same as those of the controller 11, the memory 12, the communication interface 13, the input interface 14, and the output interface 15 of the measurement apparatus 10, so a detailed description is omitted.

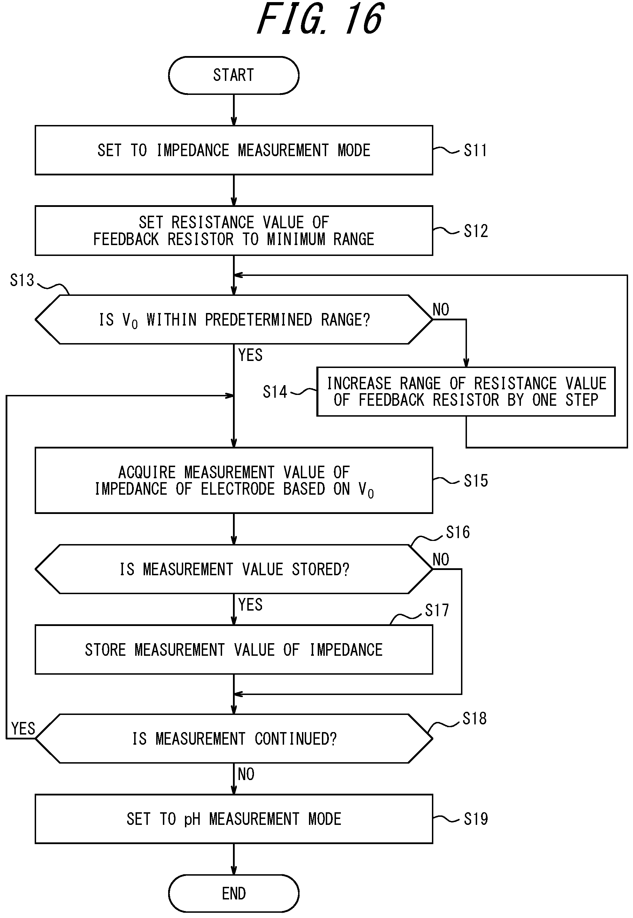

FIG. 16 is a flowchart illustrating an example of operations of the measurement apparatus 10 in FIG. 13. FIG. 16 illustrates a processing procedure by which the measurement apparatus 10 measures the impedance of an electrode to be measured. The operations of the measurement apparatus 10 described with reference to FIG. 16 may correspond to one of measurement methods by the measurement apparatus 10. An operation in each step in FIG. 16 is performed based on control by the controller 11 of the measurement apparatus 10, but all or some of the steps in FIG. 16 may be performed by the server apparatus 120 or the terminal apparatus 130.

An example in which the measurement apparatus 10 has the configuration illustrated in FIG. 11, and the feedback resistors $R_p$ of the hybrid circuits 50a and 50b have the configuration illustrated in FIGS. 7 and 9 will be described below. Although an example of operations for measuring the impedance of the glass electrode 162 will be described below, operations for measuring the impedance of the reference electrode 163 are the same.

In step S11, the controller 11 sets the measurement apparatus 10 to an impedance measurement mode, in which the impedance of an electrode to be measured is measured. Specifically, the controller 11 sets each of the switches 51a, 51b, and 61 in FIG. 11 to "B".

In step S12, the controller 11 sets the resistance value of the feedback resistor $R_p$ to a minimum range. For example, when the range of the resistance value of the feedback resistor $R_p$ is illustrated in FIG. 9, the controller 11 sets, for the feedback resistor $R_p$ of the hybrid circuit 50a, the switches S1 to S4 at setting values corresponding to Range "1". Specifically, the switch S1 is set to "B", the switch S2 is set to "A", and the switch S4 is set to "A". The setting of the switch S3 is arbitrary.

In step S13, the controller 11 determines whether the potential $V_o$ of the output terminal of the operational amplifier 53 is within a predetermined range (e.g., the measurement range of the A/D converter 54). When the potential $V_o$ is within the predetermined range (step S13: YES), the operation proceeds to step S15, and when not (step S13: NO), the operation proceeds to step S14. Here, the resistance value of the feedback resistor $R_p$ is first set to the minimum range and gradually increased, but may be first set to a maximum range and gradually decreased. In other words, there is no particular limitation on the order of varying the resistance value of the feedback resistor $R_p$, to confirm that the potential $V_o$ is kept within the predetermined range while varying the resistance value of the feedback resistor $R_p$.

In step S14, the controller 11 increases the range of the resistance value of the feedback resistor $R_p$ by one step. For example, when the range of the resistance value of the feedback resistor $R_p$ is set to Range "1" in FIG. 9, the controller 11 sets the range to Range "2". The operation then proceeds to step S13 again. The controller 11 repeats the processing of steps S13 and S14 until the potential $V_o$ is within the predetermined range, so the value of the potential $V_o$ is prevented from being rounded by the A/D converter 54, which allows acquisition of the impedance of the electrode to be measured with high accuracy.

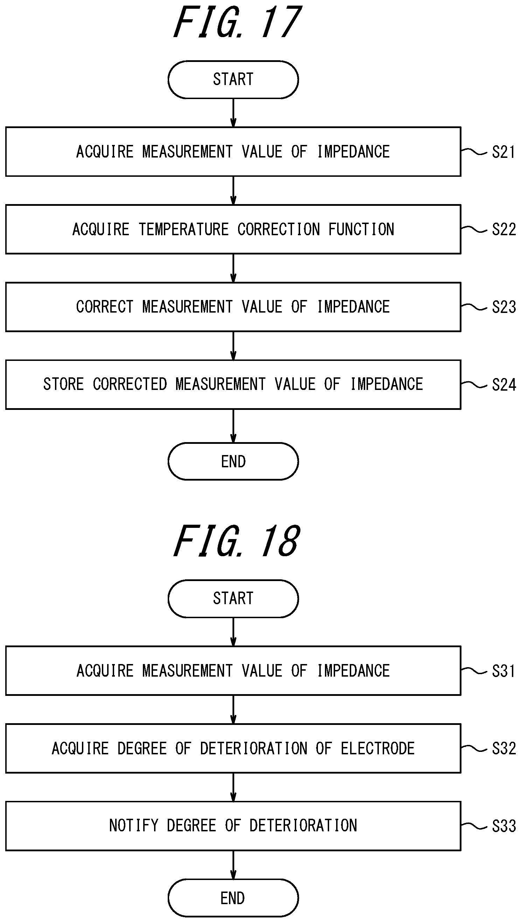

In step S15, the controller 11 acquires a measurement value of the impedance $R_x$ of the electrode to be measured, based on the potential $V_o$. Specifically, the measurement value of the impedance $R_x$ is acquired, using Equation (8), based on the potential $V_o$ and the known values $V_i$ and $R_p$. In the present embodiment, the impedance is corrected based on the temperature of the electrode to be measured in processing described later with reference to FIG. 17, but the controller 11 may correct the impedance based on the temperature in step S15.

In step S16, the controller 11 determines whether to store the measurement value of the impedance acquired in step S15. For example, the controller 11 may determine to store the measurement value in the memory 12 when a user instructs the controller 11 to do so. When the controller 11 determines to store the measurement value (step S16: YES), the operation proceeds to step S17, and when not (step S16: NO), the operation proceeds to step S18.

In step S17, the controller 11 stores, in the memory 12, the measurement value of the impedance acquired in step S15. In addition to this, the controller 11 may transmit the measurement value to the server apparatus 120 or the terminal apparatus 130 via the communication interface 13, and cause the server apparatus 120 or the terminal apparatus 130 to store the measurement value.

In step S18, the controller 11 determines whether to continue the measurement. For example, when the user instructs the controller 11 to stop measuring the impedance, the controller 11 may determine not to continue the measurement. When the controller 11 determines to continue the measurement (step S18: YES), the operation returns to step S15, and when not (step S18: NO), the operation proceeds to step S19.

In step S19, the controller 11 sets the measurement apparatus 10 to a pH measurement mode, in which the pH of the measurement solution S is measured. Specifically, the controller 11 sets each of the switches 51a, 51b, and 61 in FIG. 11 to "A". After completing the processing in step S19, the controller 11 completes the processing in the flowchart of FIG. 16.

FIG. 17 is a flowchart illustrating an example of operations of the measurement apparatus 10 in FIG. 13. FIG. 17 illustrates a processing procedure by which the measurement value of the impedance acquired based on the flowchart of FIG. 16 is corrected based on the temperature of the electrode to be measured. The operations of the measurement apparatus 10 described with reference to FIG. 17 may correspond to one of measurement methods by the measurement apparatus 10. An operation in each step in FIG. 17 is performed based on control by the controller 11 of the measurement apparatus 10, but all or some of the steps in FIG. 17 may be performed by the server apparatus 120 or the terminal apparatus 130. Although an example of operations for correcting the measurement value of the impedance of the glass electrode 162 will be described below, operations for the reference electrode 163 are the same.

In step S21, the controller 11 acquires the measurement value of the impedance of the electrode to be measured before temperature correction is performed.

In step S22, the controller 11 acquires a temperature correction function corresponding to the type of electrode to be measured. Specifically, the controller 11 acquires, from the memory 12 or the server apparatus 120, a temperature correction function corresponding to the type of glass electrode 162 used in the measurement apparatus 10.

In step S23, the controller 11 corrects the measurement value of the impedance using the temperature correction function acquired in step S22. Specifically, the controller 11 corrects the measurement value, using the temperature correction function acquired in step S22, based on the temperature of the glass electrode 162 detected by the temperature detector 17. The controller 11 may, for example, correct the measurement value of the impedance to a value corresponding to a reference temperature (e.g., 25 degrees).

In step S24, the controller 11 stores the measurement value of the impedance corrected in step S23. Specifically, the controller 11 saves the corrected measurement value in the memory 12. In addition to this, the controller 11 may transmit the corrected measurement value to the server apparatus 120 or the terminal apparatus 130 via the communication interface 13, and cause the server apparatus 120 or the terminal apparatus 130 to store the corrected measurement value. When processing in step S24 is complete, the controller 11 completes the processing in the flowchart of FIG. 17.

FIG. 18 is a flowchart illustrating an example of operations of the measurement apparatus 10 in FIG. 13. FIG. 18 illustrates a processing procedure by which the degree of deterioration of the electrode is acquired based on the measurement value of the impedance acquired based on the flowchart of FIG. 16 or the measurement value of the impedance corrected based on the flowchart of FIG. 17. The operations of the measurement apparatus 10 described with reference to FIG. 18 may correspond to one of measurement methods by the measurement apparatus 10. An operation in each step in FIG. 18 is performed based on control by the controller 11 of the measurement apparatus 10, but all or some of the steps in FIG. 18 may be performed by the server apparatus 120 or the terminal apparatus 130. Although an example of operations for acquiring the degree of deterioration of the glass electrode 162 will be described below, operations for the reference electrode 163 are the same.

In step S31, the controller 11 acquires the measurement value of the impedance of the glass electrode 162, which has been acquired based on the flowchart in FIG. 16 or corrected based on the flowchart in FIG. 17.

In step S32, the controller 11 acquires the degree of deterioration of the glass electrode 162, based on the measurement value acquired in step S31. It is generally known that the impedances of electrodes to be measured increase as the electrodes deteriorate. Therefore, the controller 11 may acquire a relational expression between the value of impedance and an indicator of the degree of deterioration, and acquire, using the relational expression, the degree of deterioration of the glass electrode 162. The value of impedance in the relational expression may be an impedance at the reference temperature corresponding to the type of electrode to be measured. In this case, it is preferable to acquire, in step S31, the measurement value of impedance that has been corrected to a value corresponding to the reference temperature based on the flowchart in FIG. 17. The controller 11 may acquire the relational expression stored in advance in the memory 12, or may receive the relational expression from the server apparatus 120 via the communication interface 13. The degree of deterioration of the electrode may be expressed numerically or at a few levels.

In step S33, the controller 11 notifies the user of the degree of deterioration acquired in step S32. For example, the degree of deterioration may be displayed on a display of the output interface 15. Specifically, the controller 11 may control the output interface 15 to display a graph representing impedances measured at multiple points in time or variation in the degree of deterioration over time, to visually represent the degree of the progression of deterioration. The controller 11 may perform regression analysis on the graph representing the variation in the degree of deterioration over time, predict timing at which the degree of deterioration reaches a predetermined threshold value, and notify the predicted timing as the timing of replacing the electrode. The controller 11 may transmit, to the terminal apparatus 130, the degree of deterioration, the timing of replacing the electrode, and the like, and cause the terminal apparatus 130 to display the degree of deterioration, the timing of replacing the electrode, and the like on a display of the output interface 135. When processing in step S33 is complete, the controller 11 terminates processing in the flowchart of FIG. 18.

As described above, the measurement apparatus 10 includes the measurement unit 16 that measures the impedance of an electrode to be measured and the controller 11. The measurement unit 16 has the operational amplifier having the inverting input terminal, the noninverting input terminal, and the output terminal, and the feedback resistor $R_p$, which is a variable resistor connected to the output terminal and the inverting input terminal of the operational amplifier. The controller 11 acquires, in a state of the inverting input terminal and the feedback resistor $R_p$ connected to one end of the electrode $R_x$ to be measured, a measurement value of the impedance of the electrode to be measured, based on a voltage applied to the other end of the electrode to be measured, the potential of the output terminal of the operational amplifier, and the resistance value of the feedback resistor $R_p$.

Accordingly, the measurement apparatus 10 can carry out measurement by adjusting the resistance value of the feedback resistor $R_p$ according to the impedance of the electrode $R_x$ to be measured. Accordingly, the measurement apparatus 10 can measure the impedance of the electrode $R_x$ to be measured simply and accurately. In addition, the measurement apparatus 10 can omit the use of an external component such as the jumper 91. For example, even when the impedance of the electrode $R_x$ to be measured is extremely high, the measurement apparatus 10 can measure the impedance of the electrode $R_x$ to be measured with high accuracy by increasing the resistance value of the feedback resistor $R_p$ according to the impedance.

The measurement apparatus 10 includes the voltage dividing resistors Ra and Rb and the feedback resistor Rc, as the feedback resistor $R_p$, as illustrated in FIG. 8, and the voltage dividing resistors Ra and Rb are arranged with the multiple switches in a binary tree structure, as illustrated in FIG. 7. Therefore, the measurement apparatus 10 can achieve the feedback resistor $R_p$ that is a variable resistor with a wide dynamic range at low cost, without using expensive high-resistance components.

The measurement apparatus 10 detects the degree of deterioration of the electrode $R_x$ to be measured, using the measurement value of the impedance of the electrode $R_x$ to be measured, which has been measured with such high accuracy, so it is possible to notify the user of the degree of deterioration of the electrode $R_x$ to be measured, the timing of replacement, and the like.

The measurement apparatus 10 notifies the user of the degree of deterioration of the electrode $R_x$ to be measured, the timing of replacement, and the like, using the output interface 15, the server apparatus 120, the terminal apparatus 130, and the like. Therefore, even when there are multiple measurement apparatuses 10, the user can properly manage each measurement apparatus 10 without having to look around for these apparatuses 10.

The measurement apparatus 10 can be switched between the pH measurement mode for measuring the pH of the measurement solution S and the impedance measurement mode for measuring the impedance of the electrode to be measured, only by switching the switches 51 (51a, 51b), 52 (52a, 52b), and 61.

The measurement apparatus 10 corrects the measurement value of the impedance of the electrode $R_x$ to be measured, based on the temperature of the electrode $R_x$ to be measured, and therefore can measure the impedance of the electrode $R_x$ to be measured with even higher accuracy.

Note that, the measurement apparatus 10 may extract a signal (corresponding to the potential $V_o$ of the output terminal) corresponding to the frequency of the applied voltage $V_i$, by passing output of the operational amplifier 53 or output of the A/D converter 54 through a lock-in amplifier (synchronous detection), a band-pass filter, or the like. With this configuration, even when the output of the operational amplifier 53 contains noise components due to a low purity of the measurement solution S, it is still possible to measure the impedance of the electrode to be measured with high accuracy.

The measurement apparatus 10 may separately include a configuration to measure the conductivity (impedance) of the measurement solution S. For example, the measurement apparatus 10 may be provided with another liquid ground, in addition to the liquid ground 164, and obtain the conductivity of the measurement solution S by applying a voltage between the two liquid grounds. Thereby, the measurement apparatus 10 can measure not only the pH but also the conductivity of the measurement solution S. In addition, the measurement apparatus 10 can measure the impedance of the electrode to be measured with even higher accuracy, by excluding the effect of the conductivity of the measurement solution S in the impedance measurement mode.

When a correlation is found between variation in the impedance value of the glass electrode 162 and variation in the pH value of the measurement solution S, the measurement apparatus 10 may correct the pH value with reference to a variation in the impedance value of the glass electrode 162. In other words, the measurement apparatus 10 may calibrate the pH value acquired based on the potential difference between the glass electrode 162 and the reference electrode 163, according to the correlation between the variation in the impedance value of the glass electrode 162 and the variation in the measurement value of the pH of the measurement solution S. With this configuration, even when the glass electrode 162 deteriorates to some extent, the measurement apparatus 10 can measure the pH value of the measurement solution S with the highest possible accuracy, regardless of such deterioration of the glass electrode 162.

The present disclosure is not limited to the embodiment described above. For example, multiple blocks illustrated in the block diagram may be integrated, or one block may be divided. Multiple steps illustrated in the flowchart may be executed in parallel or in a different order, depending on the processing capacity of the apparatus executing each step or as necessary, instead of being executed sequentially according to the description. Other modifications are also possible within the scope of not deviating from the gist of the present disclosure.

**Claims**

1. A measurement apparatus comprising:

   a measurement unit configured to measure an impedance of an electrode to be measured having first and second terminals; and
   a controller,
   wherein
   the measurement unit comprises:

   an operational amplifier having first and second input terminals and an output terminal; and
   a feedback resistor that is a variable resistor having a third terminal connected to the output terminal, and a fourth terminal connected to the first input terminal, and

   the controller is configured to acquire, in a state of the first input terminal connected to the first terminal, a measurement value of the impedance of the electrode to be measured, based on a voltage applied to the second terminal, a potential of the output terminal, and a resistance value of the feedback resistor.

2. The measurement apparatus according to claim 1 further comprising:

   a first switch configured to switch a terminal connected to the first input terminal and the fourth terminal, between a state of connecting to the first terminal and a state of not connecting to the first terminal; and
   a second switch configured to switch a terminal connected to the second input terminal, between a state of connecting to an electromotive force terminal that outputs a potential of the electrode to be measured immersed in a measurement solution that is a sample and a state of being not connected to the electromotive force terminal, wherein the controller is configured to acquire the measurement value of the impedance of the electrode to be measured, in a state of the first switch connecting the first input terminal and the fourth terminal to the first terminal, and the second switch not connecting the second input terminal to the electromotive force terminal.

3. The measurement apparatus according to claim 2, wherein the controller is configured to:

   acquire the potential of the electrode to be measured, in a state of the first switch not connecting the first input terminal and the fourth terminal to the first terminal, and the second switch connecting the second input terminal to the electromotive force terminal; and
   acquire a pH of the measurement solution based on the acquired potential of the electrode to be measured.

4. The measurement apparatus according to any one of claims 1 to 3, wherein the controller is configured to:

   acquire a temperature of the electrode to be measured; and
   correct, based on the acquired temperature, the measurement value of the impedance of the electrode to be measured.

5. The measurement apparatus according to claim 4, wherein the controller is configured to:

acquire a temperature correction function that indicates a relationship between temperature and impedance according to a type of the electrode to be measured; and
correct, using the temperature correction function, the measurement value of the impedance of the electrode to be measured.

6. The measurement apparatus according to any one of claims 1 to 5, further comprising a liquid ground circuit configured to apply a voltage to a glass electrode and a reference electrode via a measurement solution, wherein the measurement unit comprises first and second measurement units, in a state of the liquid ground circuit applying the voltage, the first measurement unit being configured to measure an impedance of the glass electrode as the electrode to be measured, and the second measurement unit being configured to measure an impedance of the reference electrode as the electrode to be measured.

7. The measurement apparatus according to claim 6, wherein the controller is configured to acquire a pH of the measurement solution based on a potential difference between the glass electrode and the reference electrode immersed in the measurement solution, in a state of the liquid ground circuit not applying the voltage.

8. The measurement apparatus according to claim 7, wherein the controller is configured to correct, based on a correlation between variation in a measurement value of the impedance of the glass electrode and variation in a measurement value of the pH of the measurement solution, the pH of the measurement solution acquired based on the potential difference between the glass electrode and the reference electrode immersed in the measurement solution.

9. The measurement apparatus according to any one of claims 1 to 8, wherein the measurement unit comprises, as the feedback resistor, a resistor whose resistance value is switchable among multiple ranges.

10. The measurement apparatus according to any one of claims 1 to 9, wherein the controller is configured to:

acquire a degree of deterioration of the electrode to be measured, based on the measurement value of the impedance of the electrode to be measured; and
output the acquired degree of deterioration.

11. The measurement apparatus according to claim 10, wherein the controller is configured to:

predict timing of replacing the electrode to be measured, based on the degree of deterioration acquired at multiple points in time; and
output the predicted timing of replacing the electrode to be measured.

12. A measurement method by a measurement apparatus comprising:

a measurement unit configured to measure an impedance of an electrode to be measured having first and second terminals; and
a controller,
wherein
the measurement unit comprises:

an operational amplifier having first and second input terminals and an output terminal; and
a feedback resistor that is a variable resistor having a third terminal connected to the output terminal, and a fourth terminal connected to the first input terminal, and

the controller is configured to acquire, in a state of the first input terminal connected to the first terminal, a measurement value of the impedance of the electrode to be measured, based on a voltage applied to the second terminal, a potential of the output terminal, and a resistance value of the feedback resistor.

*FIG. 1*

<u>90</u>

*FIG. 2*

# *FIG. 3*

MEASUREMENT CIRCUIT

# *FIG. 4*

## FIG. 5

## FIG. 6

FIG. 7

EP 4 621 399 A1

# FIG. 8

$$FIG.\ 9$$

| Range | S1 | S2 | S3 | S4 | Rc | Ra | Rb | $R_P$ |
|---|---|---|---|---|---|---|---|---|
| 1 | B | A | – | A | 1, 000 | 1, 000 | 0 | 1, 000 |
| 2 | B | A | – | B | 1, 000 | 100 | 900 | 10, 900 |
| 3 | B | B | A | – | 1, 000 | 10 | 990 | 100, 990 |
| 4 | B | B | B | – | 1, 000 | 1 | 999 | 1, 000, 999 |
| 5 | A | A | – | A | 10, 000, 000 | 1, 000 | 0 | 10, 000, 000 |
| 6 | A | A | – | B | 10, 000, 000 | 100 | 900 | 100, 000, 900 |
| 7 | A | B | A | – | 10, 000, 000 | 10 | 990 | 1, 000, 000, 990 |
| 8 | A | B | B | – | 10, 000, 000 | 1 | 999 | 10, 000, 000, 999 |

# FIG. 10

# FIG. 11

# FIG. 12

EP 4 621 399 A1

## FIG. 13

EP 4 621 399 A1

# FIG. 14

120

| CONTROLLER | ~121 |
| MEMORY | ~122 |
| COMMUNICATION INTERFACE | ~123 |

# FIG. 15

130

| CONTROLLER | ~131 | INPUT INTERFACE | ~134 |
| MEMORY | ~132 | OUTPUT INTERFACE | ~135 |
| COMMUNICATION INTERFACE | ~133 | | |

28

# FIG. 16

START

SET TO IMPEDANCE MEASUREMENT MODE — S11

SET RESISTANCE VALUE OF
FEEDBACK RESISTOR TO MINIMUM RANGE — S12

S13 — IS $V_0$ WITHIN PREDETERMINED RANGE? — NO

YES

S14 — INCREASE RANGE OF RESISTANCE VALUE
OF FEEDBACK RESISTOR BY ONE STEP

ACQUIRE MEASUREMENT VALUE OF
IMPEDANCE OF ELECTRODE BASED ON $V_0$ — S15

S16
IS MEASUREMENT VALUE STORED? — NO

YES — S17

STORE MEASUREMENT VALUE OF IMPEDANCE

YES — IS MEASUREMENT CONTINUED? — S18

NO

SET TO pH MEASUREMENT MODE — S19

END

## FIG. 17

START

ACQUIRE MEASUREMENT VALUE OF IMPEDANCE — S21

ACQUIRE TEMPERATURE CORRECTION FUNCTION — S22

CORRECT MEASUREMENT VALUE OF IMPEDANCE — S23

STORE CORRECTED MEASUREMENT VALUE OF IMPEDANCE — S24

END

## FIG. 18

START

ACQUIRE MEASUREMENT VALUE OF IMPEDANCE — S31

ACQUIRE DEGREE OF DETERIORATION OF ELECTRODE — S32

NOTIFY DEGREE OF DETERIORATION — S33

END

Europäisches
Patentamt

European
Patent Office

Office européen
des brevets

## EUROPEAN SEARCH REPORT

**Application Number**

EP 25 16 3888

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2010 0084961 A (KYUNGPOOK NAT UNIV IND ACAD [KR]) 28 July 2010 (2010-07-28) | 1,12 | INV.<br>G01N27/02 |
| Y | * paragraphs [0075] - [0077]; figure 3 * | 2,3 | G01N27/416 |
| | ----- | | |
| Y | US 2008/042665 A1 (REZVANI BEHZAD [US] ET AL) 21 February 2008 (2008-02-21)<br>* paragraphs [0016], [0019], [0021], [0025]; figure 3 * | 1,4-12 | |
| | ----- | | |
| Y | US 2021/399703 A1 (KYAKUNO TOSHIHIKO [JP]) 23 December 2021 (2021-12-23)<br>* paragraphs [0029] - [0032]; figure 1 * | 1,4-12 | |
| | ----- | | |
| Y | US 2019/313935 A1 (AL-ALI ABDULWADOOD ABDULLAH [CA] ET AL)<br>17 October 2019 (2019-10-17)<br>* paragraphs [0067] - [0070]; figure 4 * | 1,4-12 | |
| | ----- | | |
| Y | EP 0 580 326 B1 (ANATEL CORP [US])<br>3 November 1999 (1999-11-03)<br>* paragraph [0037]; figure 7 * | 1,4-12 | |
| | ----- | | **TECHNICAL FIELDS SEARCHED (IPC)** |
| Y | CN 111 220 674 A (SHANGHAI BOQU ENVIRONMENTAL TECH CO LTD)<br>2 June 2020 (2020-06-02) | 2,3 | G01N<br>G01R |
| A | * paragraphs [0031] - [0035] *<br>* figure 2 * | 1,4-12 | |
| | ----- | | |

The present search report has been drawn up for all claims

| Place of search | Date of completion of the search | Examiner |
|---|---|---|
| Munich | 17 July 2025 | Stussi, Elisa |

EPO FORM 1503 03.82 (P04C01)

## ANNEX TO THE EUROPEAN SEARCH REPORT
## ON EUROPEAN PATENT APPLICATION NO.

EP 25 16 3888

This annex lists the patent family members relating to the patent documents cited in the above-mentioned European search report.
The members are as contained in the European Patent Office EDP file on
The European Patent Office is in no way liable for these particulars which are merely given for the purpose of information.

17-07-2025

| Patent document cited in search report | | Publication date | Patent family member(s) | | Publication date |
|---|---|---|---|---|---|
| KR 20100084961 | A | 28-07-2010 | NONE | | |
| US 2008042665 | A1 | 21-02-2008 | US | 2008042665 A1 | 21-02-2008 |
| | | | WO | 2008021546 A2 | 21-02-2008 |
| US 2021399703 | A1 | 23-12-2021 | CN | 113904634 A | 07-01-2022 |
| | | | EP | 3930187 A1 | 29-12-2021 |
| | | | JP | 7494597 B2 | 04-06-2024 |
| | | | JP | 2022002384 A | 06-01-2022 |
| | | | US | 2021399703 A1 | 23-12-2021 |
| US 2019313935 | A1 | 17-10-2019 | NONE | | |
| EP 0580326 | B1 | 03-11-1999 | AT | E186405 T1 | 15-11-1999 |
| | | | CA | 2100436 A1 | 15-01-1994 |
| | | | DE | 69326921 T2 | 15-06-2000 |
| | | | EP | 0580326 A1 | 26-01-1994 |
| | | | IL | 106196 A | 08-12-1995 |
| | | | JP | H06186187 A | 08-07-1994 |
| | | | US | 5260663 A | 09-11-1993 |
| | | | US | 5334940 A | 02-08-1994 |
| CN 111220674 | A | 02-06-2020 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024043959 A
- JP 2013019804 A

- JP 2022002384 A